# EUROPEAN PATENT SPECIFICATION

(11) **EP 0 367 416 B1**
(45) Date of publication and mention of the grant of the patent: **11.08.1993**
(21) Application number: 89310223.6
(22) Date of filing: 05.10.1989
(51) Int. Cl.: H01L 39/04, H01L 39/22

(54) **Superconductive apparatus comprising a superconductive device airtightly packaged**
Supraleitender Apparat, bestehend aus einer luftdicht verpackten supraleitenden Einrichtung
Appareil supraconducteur comportant un dispositif supraconducteur emballé hermétiquement

(30) Priority: 05.10.1988 JP 252781/88
(43) Date of publication of application: 09.05.1990
(73) Proprietor: SHARP KABUSHIKI KAISHA, Osaka 545 (JP)
(72) Inventor: Shintaku, Hidetaka, Nara (JP); Tsuchimoto, Shuhei, Nara (JP); Kataoka, Shoei, Tokyo (JP)
(74) Representative: Brown, Kenneth Richard

(56) References cited:
- EP-A- 0 288 022
- US-A- 2 994 203
- NUCLEAR INSTRUMENTS AND METHODS IN PHYSICS RESEARCH, vol. A234, no. 1, January 1985, pages 61-66, Amsterdam, NL; A. BARONE et al.: "Superconducting Nb-NbxOy-Pb tunnel junctions as high resolution detectors for nuclear spectroscopy: preliminary results"
- NATURE, vol. 333, 5th May 1988, pages 29-35, Basingstoke, GB; J. CLARKE et al.: "Small-scale analog applications of high-transistion-temperature superconductors"
- IBM JOURNAL OF RESEARCH AND DEVELOPMENT, vol. 24, no. 2, March 1980, pages 167-171, New York, US; A.V. BROWN et al.: "An Overview of Josephson Packaging"

## Description

The present invention relates to a superconductive apparatus, and more particularly, to a superconductive apparatus comprising a superconductive device airtightly packaged, such as a superconductive magneto-resistive device to be used as a magnetic sensor.

Conventionally, a magnetic sensor utilising a superconductive magneto-resistive device has been proposed. In the magnetic sensor, there are formed a pair of current electrodes and a pair of voltage electrodes thereon. A current is supplied to the magnetic sensor by an external power source through lead wires which are connected to a pair of current electrodes, and a voltage generated between a pair of voltage electrodes is measured to detect a change in the resistance thereof when a magnetic field is applied thereto. Therefore, the above magnetic sensor can detect an extremely small magnetic field by measuring the above voltage. The magnetic sensor has been used at such a state that the magneto-resistive device thereof is exposed to the outside thereof.

Since superconductive apparatuses of this sort have advantages such as a simple structure and a high reliability, and also a manufacturing method thereof is relatively simple, they have been widely used. However, when the superconductive apparatuses receive a thermal cycle which changes from a room temperature to a low temperature, such as the threshold temperature of the superconductive magneto-resistive device, and vice versa, drops of water adhere to the surface of the superconductive magneto-resistive device, and the compounds of the material thereof may change to the other compounds, with the result that the superconductive property of the superconductive magneto-resistive device may deteriorate.

Further, since the surface of the superconductive magneto-resistive device is exposed to the outside thereof, it is necessary to handle it carefully.

Furthermore, since the magnetic sensitivity of the superconductive magneto-resistive device varies in dependence upon the temperature thereof, it is necessary to measure the temperature of the superconductive magneto-resistive device upon cooling it in order to correct the measurement result of the magnetic field according to the above temperature dependency.

From NUCLEAR INSTRUMENTS AND METHODS IN PHYSICS RESEARCH, vol. A234, No. 1, January 1985, pages 61-66, Amsterdam, NL; A. BARONE et al.: "Superconducting NbNbₓO_{y}-Pb tunnel junctions as high resolution detectors for nuclear spectroscopy: preliminary results", there is known an experimental apparatus in which a superconductive device is held in a container having a high vacuum state and unterminated micro coax cables for connecting electrodes of said superconductive device to an external apparatus.

An essential object of the present invention is to provide a superconductive apparatus comprising a superconductive device wherein the superconductive property thereof does not deteriorate even after cooling it and it is not necessary to handle it carefully.

Another aim of the present invention is to provide a superconductive apparatus comprising a superconductive device, which permits measurement of the temperature of the superconductive device accurately.

In order to accomplish the above object, according to one aspect of the present invention, there is provided a superconductive apparatus comprising: a superconductive device having electrodes; and an airtight package within which said superconductive device is mounted, wherein said airtight package has external terminals for connecting the electrodes of said superconductive device to external apparatus, and said airtight package is sealed and contains said superconductive device in an atmosphere which can be attained after replacing the internal air thereof with a gas which does not cause any reaction within the airtight package.

With this construction, drops of water, for example, can be prevented from adhering to the superconductive device so that the superconductive magneto-resistive property of the superconductive apparatus almost does not, as a consequence, deteriorate. Thus, the reliability of the superconductive apparatus is improved.

From EP-A-0,288,022, which, for the designated states DE, FR, GB, forms part of the state of the art by virtue of Article 54(3) EPC, it is known to mount a superconductive device within an airtight container in an atmosphere of inert gas, and to provide terminals for connection to external equipment. The superconductive device is used as a Josephson element, a magnetic sensor, a signal amplifying element, switching element.

According to another aspect of the present invention, the superconductive apparatus further comprises a resistance thermometer mounted within the airtight package at a position which enables accurate measurement of the temperature of said superconductive device.

Therefore, the temperature of the superconductor can be measured accurately, and by correcting the magnetic sensitivity of the superconductive magneto-resistive device, an extremely small magnetic field can be measured accurately.

The present invention will become clear from the following description of a preferred embodiment, taken in conjunction with the accompanying drawings, in which:
Fig. 1 is a top plan view of a superconductive magnetic sensor of a preferred embodiment according to the present invention;
Fig. 2 is a schematic view showing a spray pyrolysis method for making a superconductive film used for the superconductive magnetic sensor shown in Fig. 1;
Fig. 3 is a graph showing a superconductive magneto-resistive property of the magnetic sensor shown in Fig. 1;
Fig. 4 is a top plan view of a platinum resistance thermometer to be used for measuring the temperature of the magnetic sensor shown in Fig. 1;
Fig. 5 is a top plan view of a superconductive magnetic field measuring apparatus utilizing the magnetic sensor shown in Fig. 1 and the platinum resistance thermometer shown in Fig. 4, which are packaged within a ceramic package;
Fig. 6 is a top plan view of a glass plate for sealing the ceramic package on which a thermal hardening type resin is coated so as to form grooves thereof; and
Fig. 7 is a graph showing the result obtained by a cycle test at which one cycle operation, consisting of a room temperature operation and a liquid nitrogen operation, is repeated several tens of times for the packaged magnetic sensor and the conventional non-packaged magnetic sensor.

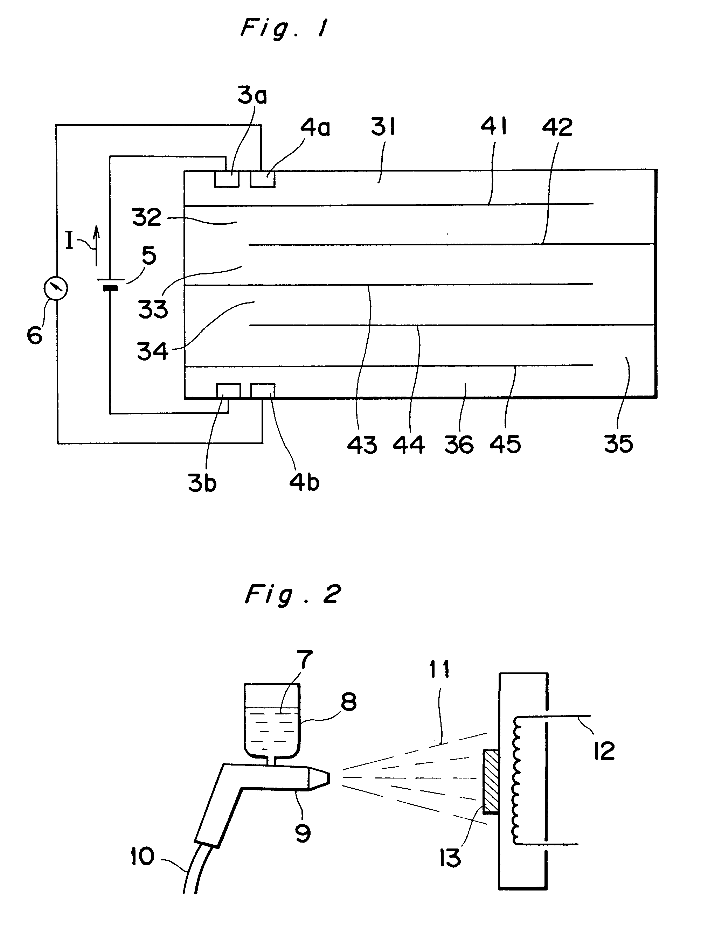

Fig. 1 shows a superconductive magneto-resistive device for use in apparatus according to a preferred embodiment of the present invention, made by a spray pyrolysis method, wherein the superconductive magneto-resistive device comprises superconductive strips 31 to 36 having point contact type weak couplings between grain boundaries thereof, the superconductor strips 31 to 36 being connected in series.

The superconductive magneto-resistive device is made of a Y-Ba-Cu-O ceramic compound, and materials of Y(NO₃)₃·6H₂O, Ba(NO₃)₂ and Cu(NO₃)₂·3H₂O are used to produce the superconductive magneto-resistive device.

Powders of Y(NO₃)₃·6H₂O, Ba(NO₃)₂ and Cu(NO₃)₂·3H₂O are weighed so that a composition ratio of Y, Ba and Cu becomes 1 : 2 : 3 in order to obtain a component of Y₁Ba₂Cu₃O₇₋ₓ (0 < x < 1). Each powder is sufficiently dissolved in pure water so as to prepare an aqueous solution containing Y, Ba, Cu nitrates. Thereafter, a magnetic sensor of the present preferred embodiment is made by the following method as described with reference to Fig. 2.

The aqueous solution 7 containing Y, Ba, Cu nitrates which is made as described above is put into a container 8 of a spray gun 9. The aqueous solution 7 is made into spray 11 having extremely minute particles by stirring it up sufficiently, and is sprayed over an yttrium-stabilized zirconia substrate 13 which is heated at about 600°C by a heater 12, with use of the spray gun 9 using compressed air 10. Then, the aqueous solution 7 is repeatedly sprayed over by an extremely small quantity thereof about one hundred times at a relatively slow spraying speed without decreasing the temperature of the substrate 13, so as to form a film having a thickness of about 10 µm on the substrate 13.

In the above spray pyrolysis method, N₂ gas or O₂ gas can be used as the compressed air 10 of the spray gun 9. A good quality of film having a thickness in the range from 0.5 µm to 50 µm was made by the above spray pyrolysis method. The film having a thickness in the range from about 1 µm to about 10 µm acted as a magnetic sensor having excellent characteristics. In the above spray pyrolysis method, the temperature at which the substrate 13 is heated may be changed in the range from 300° to 600°C.

The film made by the above spray pyrolysis method is heated at 950°C for about 30 minutes in air, and is sintered with cooling it gradually so as to form a ceramic superconductive film. The sintering temperature may be changed in the range from 900°C to 1000°C, and the time for sintering the film may be changed in the range from about one minute to about sixty minutes depending on the thickness of the superconductive film to be formed.

It is to be noted that, when the thickness of the formed superconductive film is equal to or smaller than 0.2 µm, the filling rate of the formed superconductive film decreases and the uniformity thereof deteriorates. Furthermore, when the thickness thereof is larger than about 50 µm, the superconductive film cannot be formed fitly and tightly on the substrate 13, and also the measuring current to be supplied to the magnetic sensor upon measuring the magnetic flux density must be increased in order to obtain a predetermined sensitivity of the magnetic sensor.

The magnetic sensor is made as shown in Fig. 1 by using the superconductive film made by the spray pyrolysis method.

Referring to Fig. 1, in the structure of the magnetic sensor, five slits 41 to 45 are formed in the superconductive film so as to divide the film up into six superconductive strips 31 to 36 connected in series. In this way, a folded current path is formed in the magnetic sensor. On the ends of the folded current path, i.e. on respective ends of the two outermost strips 31 and 36, a pair of current electrodes 3a and 3b of Ti and a pair of voltage electrodes 4a and 4b of Ti are formed fitly and tightly by the vapour deposition method, respectively. A pair of current electrodes 3a and 3b are connected to a constant-current regulated power source 5 for supplying a constant current I through lead wires bonded on the electrodes 3a and 3b with us of Ag paste. A pair of voltage electrodes 4a and 4b are connected to a voltmeter 6 for measuring a voltage generated in the magnetic sensor through lead wires bonded on the electrodes 4a and 4b with use of Ag paste.

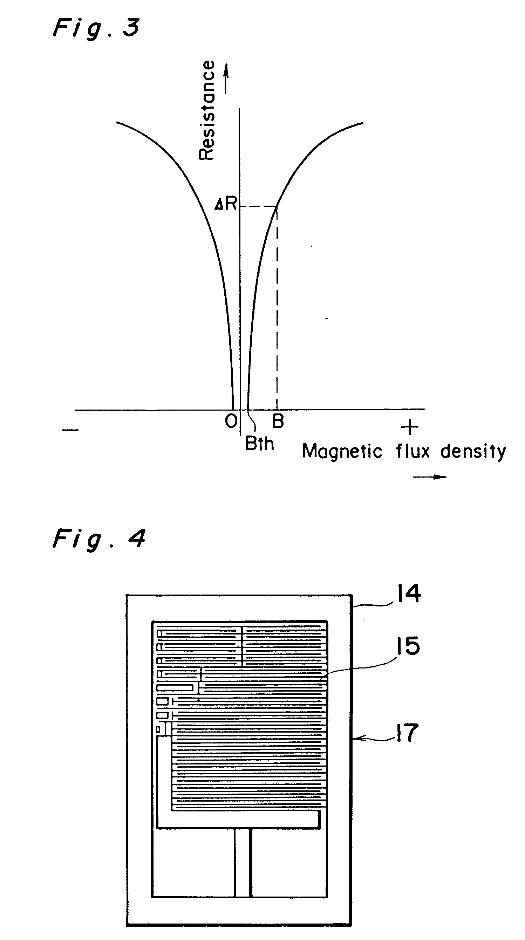

Fig. 3 is a graph showing the result obtained by measurement with use of the magnetic sensor shown in Fig. 1 when immersed in liquid nitrogen (77K). This magneto-resistive characteristic is obtained when a current of 1 mA is supplied to the magnetic sensor having a thickness of 10 µm. As shown in Fig. 3, the resistance of the magnetic sensor is kept at zero in the superconductive phase until the magnetic flux density B of a magnetic field applied thereto is increased up to a threshold value Bth, but it increases very steeply when the magnetic flux density B is increased over the threshold value Bth.

Fig. 4 shows a platinum resistance thermometer 17 to be used for measuring the temperature of the magnetic sensor. The platinum resistance thermometer 17 is made as follows.

First of all, a film 15 of platinum having a thickness in the range from several hundred nm (several thousand Å) to several micron is formed on substrate 14 of alumina by a sputtering method etc. Thereafter, a photoresist pattern is formed on the film 15 of platinum, and then, the film 15 of platinum is etched with use of the above photoresist pattern film by a sputtering etching method so as to have a predetermined pattern. Furthermore, after the photoresist pattern film is removed therefrom, the film 15 of platinum formed on the substrate 14 of alumina is heated at a high temperature of about 1000°C in air, and is shaped by a trimming method so as to have a predetermined resistance, resulting in that the platinum resistance thermometer 17 is obtained.

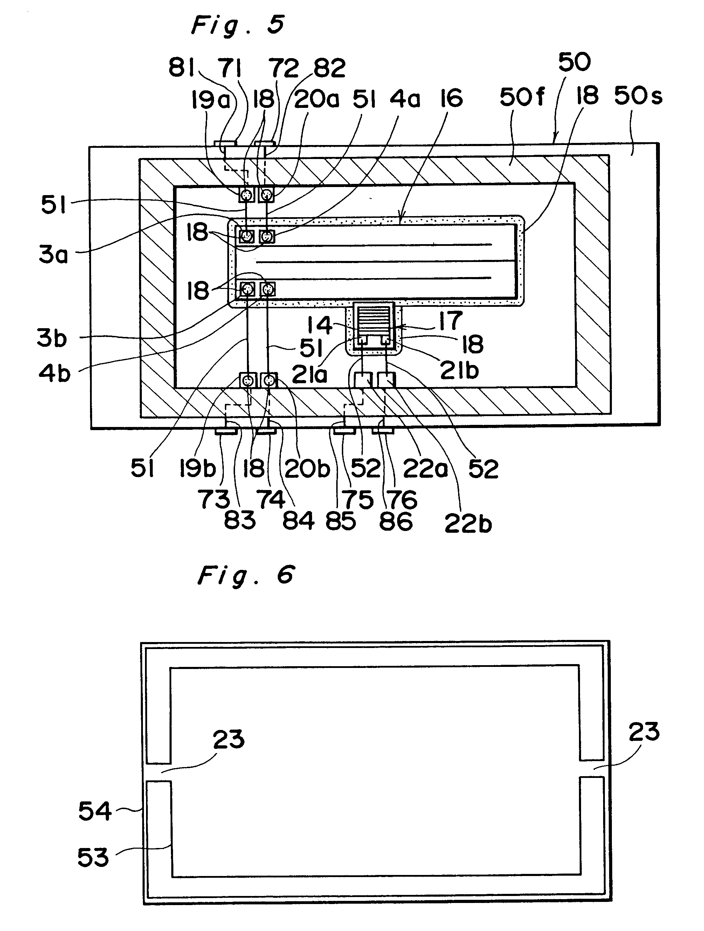

The superconductive magnetic sensor 16 and the platinum resistance thermometer 17, which are made as described above, are mounted on a ceramic package 50 as shown in Fig. 5 as follows.

The ceramic package 50 comprises a ceramic substrate 50s and a frame-shaped ceramic enclosure 50f which is bonded on the substrate 50s. On the outside surface of the substrate 50s, there are mounted six external pins 71 to 76, and the external pins 71 to 76 are electrically connected to internal terminals 19a, 20a, 19b, 20b, 22a and 22b, respectively, through Cu connection lines 81 to 86 formed on the surface of the substrate 50s.

The superconductive magnetic sensor 16 and the platinum resistance thermometer 17 are bonded on the ceramic substrate 50s of the ceramic package 50 with use of thermal hardening type Ag paste 18 so that they are close to each other. The platinum resistance thermometer 17 is used for measuring the temperature of the superconductive magnetic sensor 16, and a good thermal contact characteristic between the magnetic sensor 16 and the thermometer 17 can be obtained. Furthermore, since the substrate 14 of the platinum resistance thermometer 17 has substantially the same thermal conductivity as that of the magnetic sensor 16, the temperature of the superconductor of the magnetic sensor can be measured accurately. A pair of current electrodes 3a and 3b and a pair of voltage electrodes 4a and 4b of the magnetic sensor are respectively connected to the internal terminals 19a, 19b, 20a and 20b formed on the inner surface of the ceramic substrate 50s of the ceramic package 50, within the ceramic enclosure 50f, through lead wires 51 with use of the same thermal hardening type Ag paste 18 as that used upon bonding the lead wires onto the electrodes 3a, 3b, 4a and 4b, resulting in that a pair of current electrodes 3a and 3b and a pair of voltage electrodes 4a and 4b are connected to the external pins 71, 73, 72 and 74 of the ceramic package 50, respectively. Thereafter, the magnetic sensor is heated at 150°C for thirty minutes within a clean oven so that the Ag paste 18 is hardened. Finally, electrodes 21a and 21b of the platinum resistance thermometer 17 are respectively connected to the internal terminals 22a and 22b formed on the inner surface of the ceramic substrate 50s of the ceramic package 50, within the ceramic enclosure 50f, through lead wires 52 by a bonding method, resulting in that the electrodes 21a and 21b are respectively connected to the external pins 75 and 76 of the ceramic package 50.

After a thermal hardening type resin 53, having a relatively low thermal hardening temperature such as 110°C to 150°C, has been coated on a glass plate 54 for sealing the ceramic package 50 so as to form grooves 23 for ventilating between the inside of the ceramic package 50 and the outside thereof, the ceramic package 50 is sealed by the glass plate 54. Then, after the inside of the ceramic package 50 is made vacuous at a degree of vacuum of 1.33 Nm⁻² (10 mTorr) or less, nitrogen gas having a purity of 99.99% or less is filled therein until the internal pressure thereof becomes 1.11 x 10⁵ Nm⁻² (1.1 atmospheric pressure), resulting in that the internal air within the ceramic package 50 is replaced with the nitrogen gas. Finally, the glass plate 54 is heated and pressed on the ceramic package 50 at 110°C for 60 minutes, and further, it is heated and pressed thereon at 150°C for 60 minutes so as to be completely bonded thereon, resulting in that a superconductive magnetic field measuring apparatus is made.

In the superconductive apparatus as constructed above, since the superconductive magnetic sensor 16 is bonded on the ceramic substrate 50s with use of the Ag paste 18 having a high thermal conductivity, there is almost no difference between the temperatures of the ceramic substrate 50s and the magnetic sensor 16 upon cooling them, resulting in that the magnetic sensor 16 can be cooled at substantially the same temperature as that at which the ceramic substrate 50s is cooled. Further, since the lead wires 51 and 52 are bonded on the internal terminals 19a, 19b, 20a, 20b, 22a and 22b, and the electrodes 3a, 3b, 4a, 4b, 21a and 21b with use of the Ag paste 18 having a high electrical conductivity, they are electrically connected to each other, certainly. Furthermore, since the internal air within the ceramic package 50 is replaced with nitrogen gas, which is an inert gas, namely, the internal gas does not include an active gas such as oxygen gas, no reaction is caused within the ceramic package 50.

In the above preferred embodiment, the magnetic sensor utilizing the superconductive magneto-resistive device is described. However, other superconductive apparatus, utilizing, for example, a superconductive transistor or a Josephson device, may be packaged in the same manner as that of the present preferred embodiment in order to improve the reliability of the superconductive apparatus.

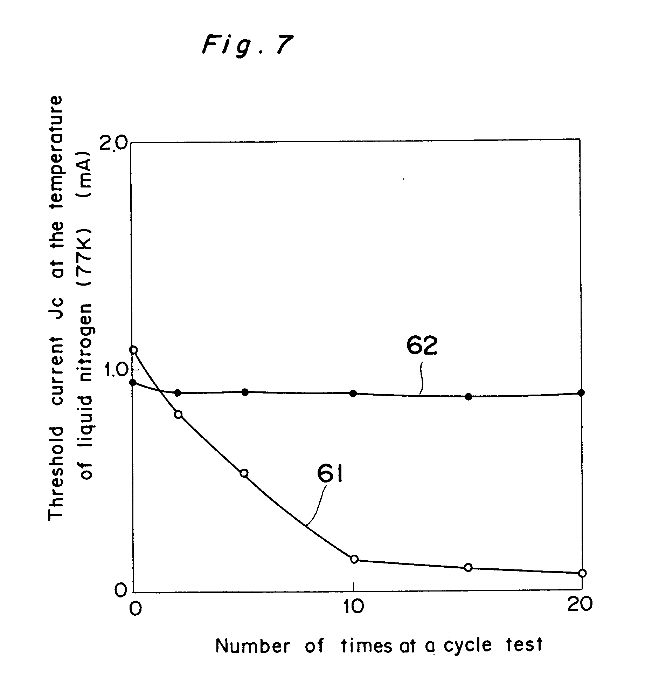

Fig. 7 shows the result obtained by a cycle test, in which one cycle of operation consists of a room temperature operation at which the apparatus is placed at room temperature for ten minutes and a liquid nitrogen operation at which it is cooled at the temperature of liquid nitrogen (77K), in which the cycle is repeated several tens of times for the packaged magnetic sensor and the conventional non-packaged magnetic sensor.

As shown by the characteristic 61 of Fig. 7, when the conventional magnetic sensor (not packaged) is repeatedly cooled at such a state that the superconductive magneto-resistive device is exposed to the atmosphere until the temperature thereof becomes the threshold temperature thereof or less, the magneto-resistive property thereof deteriorates due to drops of water adhering to the surface of the superconductive magneto-resistive device. However, after the above one cycle operation is repeated for the packaged superconductive magnetic field measuring apparatus several tens of times, as shown by the characteristic 62 of Fig. 7, the threshold current Jc of the superconductive magneto-resistive device at the temperature of liquid nitrogen (77K) almost does not decrease. Therefore, stable operation of the measuring apparatus can be obtained.

## Claims (Claims for the following Contracting State(s): CH, IT, LI, NL)

1. A superconductive apparatus comprising a superconductive device (16) having electrodes (3a, 3b, 4a, 4b), and an airtight package (50, 54) within which said superconductive device is mounted, wherein said airtight package has external terminals (71 - 74) for connecting the electrodes of said superconductive device to external apparatus, and said airtight package is sealed and contains said superconductive device in an atmosphere which can be attained after replacing the internal air thereof with a gas which does not cause any reaction within the airtight package.

2. The superconductive apparatus as claimed in claim 1, further comprising a resistance thermometer (17) mounted within said airtight package at a position which enables measurement of the temperature of said superconductive device (16).

3. The superconductive apparatus as claimed in claim 2, wherein said resistance thermometer (17) is a platinum resistance thermometer.

4. The superconductive apparatus as claimed in any one of claims 1 to 3, wherein said superconductive device (16) is a superconductive magneto-resistive device.

5. The superconductive apparatus as claimed in claim 4, wherein said superconductive magneto-resistive device (16) is a magnetic sensor.

6. The superconductive apparatus as claimed in any one of claims 1 to 3, wherein said superconductive device (16) is a superconductive transistor.

7. The superconductive apparatus as claimed in any one of claims 1 to 3, wherein said superconductive device (16) is a Josephson device.

8. The superconductive apparatus as claimed in any one of the preceding claims, wherein said superconductive device (16) is bonded on said airtight package (50s) with use of Ag paste (18).

9. The superconductive apparatus as claimed in any one of claims 2 to 5, or any one of claims 6 to 8 as appendent to claim 2, wherein said resistance thermometer (17) is bonded on said airtight package (50s) with use of Ag paste (18).

10. The superconductive apparatus as claimed in any one of the preceding claims, wherein said airtight package comprises a ceramic enclosure (50f) sandwiched between a ceramic substrate (50s) and a glass plate (54), said superconductive device (16) being mounted on said ceramic substrate (50s).

11. The superconductive apparatus as claimed in claim 10, wherein said external terminals (71 - 74) are mounted on the outside surface of said ceramic substrate (50s).

12. The superconductive apparatus as claimed in claim 11, wherein each of said external terminals is an external pin (e.g. 71) electrically connected to an internal terminal (e.g. 19a) inside said ceramic enclosure (50f), said internal terminal and said external pin being connected by a Cu connection line (e.g. 81) formed on the surface of said ceramic substrate (50s).

13. The superconductive apparatus as claimed in any one of the preceding claims, wherein said gas is nitrogen gas.

14. The superconductive apparatus as claimed in any one of the preceding claims, wherein said gas is filled in said airtight package (50, 54) at a pressure of 1.11 x 10⁵ Nm⁻² (1.1 atmospheric pressure).

## Claims (Claims for the following Contracting State(s): DE, FR, GB)

1. A superconductive apparatus comprising:
a superconductive device (16) having electrodes (3a, 3b, 4a, 4b);
a sealed airtight package (50, 54) within which said superconductive device is mounted in an atmosphere which can be attained after replacing the internal air thereof with a gas which does not cause any reaction within the airtight package;
said airtight package having external terminals (71 - 74) for connecting the electrodes of said superconductive device to external apparatus; and
a resistance thermometer (17) mounted within said airtight package at a position which enables measurement of the temperature of said superconductive device (16).

2. The superconductive apparatus as claimed in claim 1, wherein said resistance thermometer (17) is a platinum resistance thermometer.

3. The superconductive apparatus as claimed in claim 1 or claim 2, wherein said superconductive device (16) is a superconductive magneto-resistive device.

4. The superconductive apparatus as claimed in claim 3, wherein said superconductive magneto-resistive device (16) is a magnetic sensor.

5. The superconductive apparatus as claimed in claim 1 or claim 2, wherein said superconductive device (16) is a superconductive transistor.

6. The superconductive apparatus as claimed in claim 1 or claim 2, wherein said superconductive device (16) is a Josephson device.

7. The superconductive apparatus as claimed in any one of the preceding claims, wherein said superconductive device (16) is bonded on said airtight package (50s) with use of Ag paste (18).

8. The superconductive apparatus as claimed in any one of the preceding claims, wherein said resistance thermometer (17) is bonded on said airtight package (50s) with use of Ag paste (18).

9. The superconductive apparatus as claimed in any one of the preceding claims, wherein said airtight package comprises a ceramic enclosure (50f) sandwiched between a ceramic substrate (50s) and a glass plate (54), said superconductive device (16) being mounted on said ceramic substrate (50s).

10. The superconductive apparatus as claimed in claim 9, wherein said external terminals (71 - 74) are mounted on the outside surface of said ceramic substrate (50s).

11. The superconductive apparatus as claimed in claim 10, wherein each of said external terminals is an external pin (e.g. 71) electrically connected to an internal terminal (e.g. 19a) inside said ceramic enclosure (50f), said internal terminal and said external pin being connected by a Cu connection line (e.g. 81) formed on the surface of said ceramic substrate (50s).

12. The superconductive apparatus as claimed in any one of the preceding claims, wherein said gas is nitrogen gas.

13. The superconductive apparatus as claimed in any one of the preceding claims, wherein said gas is filled in said airtight package (50, 54) at a pressure of 1.11 x 10⁵ Nm⁻² (1.1 atmospheric pressure).

## Patentansprüche (Patentansprüche für folgende(n) Vertragsstaat(en): CH, IT, LI, NL)

1. Supraleitender Apparat, bestehend aus einer supraleitenden Vorrichtung (16) mit Elektroden (3a, 3b, 4a, 4b) und einer luftdichten Packung (50, 54), in welcher die supraleitende Vorrichtung angebracht ist, dadurch gekennzeichnet, dass die luftdichte Packung aussenliegende Anschlüsse (71-74) hat für den Anschluss der Elektroden Supraleitendern Vorrichtung an externe Apparate, und dass die luftdichte Packung abgedichtet ist und die supraleitende Vorrichtung in einer Atmosphäre enthält, welche erzielt werden kann nach dem Ersatz der Innenluft darin durch ein Gas, welches keine Reaktion innerhalb der luftdichten Packung verursacht.

2. Supraleitender Apparat nach Anspruch 1, dadurch gekennzeichnet, dass er im weiteren aus einem Widerstands-Thermometer (17) besteht, das innerhalb der luftdichten Packung angebracht ist an einer Stelle, welche die Messung der Temperatur Supraleitendern Vorrichtung (16) ermöglicht.

3. Supraleitender Apparat nach Anspruch 2, dadurch gekennzeichnet, dass das Widerstands-Thermometer (17) ein Platin-Widerstands-Thermometer ist.

4. Supraleitender Apparat nach einem der Ansprüche 1 bis 3, dadurch gekennzeichnet, dass die supraleitende Vorrichtung (16) eine supraleitende magneto-resistive Vorrichtung ist.

5. Supraleitender Apparat nach Anspruch 4, dadurch gekennzeichnet, dass die supraleitende magneto-resistive Vorrichtung (16) ein magnetischer Fühler ist.

6. Supraleitender Apparat nach einem der Ansprüche 1 bis 3, dadurch gekennzeichnet, dass die supraleitende Vorrichtung (16) ein supraleitender Transistor ist.

7. Supraleitender Apparat nach einem der Ansprüche 1 bis 3, dadurch gekennzeichnet, dass die supraleitende Vorrichtung (16) eine Josephson-Vorrichtung ist.

8. Supraleitender Apparat nach einem der Ansprüche 1 bis 7, dadurch gekennzeichnet, dass die supraleitende Vorrichtung (16) verbunden ist mit der luftdichten Packung (50s), unter Verwendung von Ag-Paste (18).

9. Supraleitender Apparat nach einem der Ansprüche 2 bis 8, dadurch gekennzeichnet, dass das Widerstands-Thermometer (17) verbunden ist mit der luftdichten Packung (50s), unter Verwendung von Ag-Paste (18).

10. Supraleitender Apparat nach einem der Ansprüche 1 bis 9, dadurch gekennzeichnet, dass die luftdichte Packung aus einer Keramik-Hülle (50f) besteht, welche eingelegt ist zwischen einem Keramik-Substrat (50s) und einer Glasplatte (54), wobei die supraleitende Vorrichtung (16) auf dem Keramik-Substrat (50s) angebracht ist.

11. Supraleitender Apparat nach Anspruch 10, dadurch gekennzeichnet, dass die aussenliegenden Anschlüsse (71-74) auf der Aussen-Oberfläche des Keramik-Substrats (50s) angebracht sind.

12. Supraleitender Apparat nach Anspruch 11, dadurch gekennzeichnet, dass jeder der aussenliegenden Anschlüsse ein aussenliegender Stift (z.B. 71) ist, der elektrisch verbunden ist mit einem innenliegenden Anschluss (z.B. 19a) in Innern der Keramik-Hülle (50f), wobei der innenliegende Anschluss und der aussenliegende Stift über eine Cu-Verbindungsleitung (z.B. 81) verbunden sind, welche auf der Oberfläche des Keramik-Substrats (50s) angeordnet ist.

13. Supraleitender Apparat nach einem der Ansprüche 1 bis 12, dadurch gekennzeichnet, dass das Gas Stickstoff-Gas ist.

14. Supraleitender Apparat nach einem der Ansprüche 1 bis 13, dadurch gekennzeichnet, dass das Gas eingefüllt ist in die luftdicke Packung (50, 54) unter einem Druck von 1,11 x 10⁵ Nm⁻² (1,1-facher atmosphärischer Druck).

## Patentansprüche (Patentansprüche für folgende(n) Vertragsstaat(en): DE, FR, GB)

1. Supraleitender Apparat, bestehend aus:
einer supraleitenden Vorrichtung (16) mit Elektroden (3a, 3b, 4a, 4b);
einer abgedichteten luftdichten Packung (50, 54), in welcher die supraleitende Vorrichtung angebracht ist in einer Atmosphäre, welche erzielt werden kann nach dem Ersatz der Innenluft darin durch ein Gas, welches keine Reaktion innerhalb der luftdichten Packung verursacht;
der luftdichten Packung mit aussenliegenden Anschlüssen (71-74) für den Anschluss der Elektroden Supraleitendern Vorrichtung an externe Apparate; und
einem Widerstands-Thermometer (17), das innerhalb der luftdichten Packung angebracht ist an einer Stelle, welche die Messung der Temperatur Supraleitendern Vorrichtung (16) ermöglicht.

2. Supraleitender Apparat nach Anspruch 1, dadurch gekennzeichnet, dass das Widerstands-Thermometer (17) ein Platin-Widerstands-Thermometer ist.

3. Supraleitender Apparat nach Anspruch 1 oder 2, dadurch gekennzeichnet, dass die supraleitende Vorrichtung (16) eine supraleitende magneto-resistive Vorrichtung ist.

4. Supraleitender Apparat nach Anspruch 3, dadurch gekennzeichnet, dass die supraleitende magneto-resistive Vorrichtung (16) ein magnetischer Fühler ist.

5. Supraleitender Apparat nach Anspruch 1 oder 2, dadurch gekennzeichnet, dass die supraleitende Vorrichtung (16) ein supraleitender Transistor ist.

6. Supraleitender Apparat nach Anspruch 1 oder 2, dadurch gekennzeichnet, dass die supraleitende Vorrichtung (16) eine Josephson-Vorrichtung ist.

7. Supraleitender Apparat nach einem der Ansprüche 1 bis 6, dadurch gekennzeichnet, dass die supraleitende Vorrichtung (16) verbunden ist mit der luftdichten Packung (50s), unter Verwendung von Ag-Paste (18).

8. Supraleitender Apparat nach einem der Ansprüche 1 bis 7, dadurch gekennzeichnet, dass das Widerstands-Thermometer (17) verbunden ist mit der luftdichten Packung (50s), unter Verwendung von Ag-Paste (18).

9. Supraleitender Apparat nach einem der Ansprüche 1 bis 8, dadurch gekennzeichnet, dass die luftdichte Packung aus einer Keramik-Hülle (50f) besteht, welche eingelegt ist zwischen einem Keramik-Substrat (50s) und einer Glasplatte (54), wobei die supraleitende Vorrichtung (16) auf dem Keramik-Substrat (50s) angebracht ist.

10. Supraleitender Apparat nach Anspruch 9, dadurch gekennzeichnet, dass die aussenliegenden Anschlüsse (71-74) auf der Aussen-Oberfläche des Keramik-Substrats (50s) angebracht sind.

11. Supraleitender Apparat nach Anspruch 10, dadurch gekennzeichnet, dass jeder der aussenliegenden Anschlüsse ein aussenliegender Stift (z.B. 71) ist, der elektrisch verbunden ist mit einem innenliegenden Anschluss (z.B. 19a) in Innern der Keramik-Hülle (50f), wobei der innenliegende Anschluss und der aussenliegende Stift über eine Cu-Verbindungsleitung (z.B. 81) verbunden sind, welche auf der Oberfläche des Keramik-Substrats (50s) angeordnet ist.

12. Supraleitender Apparat nach einem der Ansprüche 1 bis 11, dadurch gekennzeichnet, dass das Gas Stickstoff-Gas ist.

13. Supraleitender Apparat nach einem der Ansprüche 1 bis 12, dadurch gekennzeichnet, dass das Gas eingefüllt ist in die luftdicke Packung (50, 54) unter einem Druck von 1,11 x 10⁵ Nm⁻² (1,1-facher atmosphärischer Druck).

## Revendications (Revendications pour l'(les) Etat(s) contractant(s) suivant(s): CH, IT, LI, NL)

1. Appareil supraconducteur comprenant un dispositif supraconducteur (16) ayant des électrodes (3a, 3b, 4a, 4b) et un boîtier (50, 54) étanche à l'air, à l'intérieur duquel est monté ledit dispositif supraconducteur, dans lequel ledit boîtier étanche à l'air a des bornes externes (71 - 74) pour la connexion des électrodes dudit dispositif supraconducteur à un appareil externe, ledit boîtier étanche à l'air étant scellé et contenant ledit dispositif supraconducteur dans une atmosphère qui peut être obtenue après avoir remplacé l'air à l'intérieur de celui-ci par un gaz qui ne provoque aucune réaction dans le boîtier étanche à l'air.

2. Appareil supraconducteur selon la revendication 1, comprenant en outre un thermomètre à résistance (17) monté à l'intérieur dudit boîtier étanche à l'air dans une position permettant la mesure de la température dudit dispositif supraconducteur (16).

3. Appareil supraconducteur selon la revendication 2, dans lequel ledit thermomètre à résistance (17) est un thermomètre à résistance de platine.

4. Appareil supraconducteur selon l'une quelconque des revendications 1 à 3, dans lequel ledit dispositif supraconducteur (16) est un dispositif magnétorésistif supraconducteur.

5. Appareil supraconducteur selon la revendication 4, dans lequel ledit dispositif magnétorésistif supraconducteur (16) est un détecteur magnétique.

6. Appareil supraconducteur selon l'une quelconque des revendications 1 à 3, dans lequel ledit dispositif supraconducteur (16) est un transistor supraconducteur.

7. Appareil supraconducteur selon l'une quelconque des revendications 1 à 3, dans lequel ledit dispositif supraconducteur (16) est un dispositif Josephson.

8. Appareil supraconducteur selon l'une quelconque des revendications précédentes, dans lequel ledit dispositif supraconducteur (16) est fixé sur ledit boîtier (50s) étanche à l'air au moyen d'une pâte d'Ag (18).

9. Appareil supraconducteur selon l'une quelconque des revendications 2 à 5, ou l'une quelconque des revendications 6 à 8, en tant que dépendantes de la revendication 2, dans lequel ledit thermomètre à résistance (17) est fixé sur ledit boîtier (50s) étanche à l'air au moyen d'une pâte d'Ag (18).

10. Appareil supraconducteur selon l'une quelconque des revendications précédentes, dans lequel ledit boîtier étanche à l'air comprend une enceinte en céramique (50f) prise en sandwich entre un substrat en céramique (50s) et une plaque de verre (54), ledit dispositif supraconducteur (16) étant monté sur ledit substrat en céramique (50s).

11. Appareil supraconducteur selon la revendication 10, dans lequel lesdites bornes externes (71 - 74) sont montées sur la surface extérieure dudit substrat en céramique (50s).

12. Appareil supraconducteur selon la revendication 11, dans lequel chacune desdites bornes externes est une broche externe (par exemple 71) électriquement connectée à une borne interne (par exemple 19a) à l'intérieur de ladite enceinte en céramique (50f), ladite borne interne et ladite broche externe étant reliées par une ligne de connexion en Cu (par exemple 81) formée sur la surface dudit substrat en céramique (50s).

13. Appareil supraconducteur selon l'une quelconque des revendications précédentes, dans lequel ledit gaz est de l'azote.

14. Appareil supraconducteur selon l'une quelconque des revendications précédentes, dans lequel ledit gaz remplit ledit boîtier (50, 54) étanche à l'air à une pression de 1,11 x 10⁵ Nm⁻² (pression atmosphérique 1,1).

## Revendications (Revendications pour l'(les) Etat(s) contractant(s) suivant(s): DE, FR, GB)

1. Appareil supraconducteur, comprenant :
un dispositif supraconducteur (16) ayant des électrodes (3a, 3b, 4a, 4b) ;
un boîtier (50, 54) étanche à l'air scellé, à l'intérieur duquel ledit dispositif supraconducteur est monté dans une atmosphère qui peut être obtenue après avoir remplacé l'air à l'intérieur de celui-ci par un gaz qui ne provoque aucune réaction dans le boîtier étanche à l'air ;
ledit boîtier étanche à l'air ayant des bornes externes (71 - 74) pour la connexion des électrodes dudit dispositif supraconducteur à un appareil externe ; et
un thermomètre à résistance (17) monté à l'intérieur dudit boîtier étanche à l'air dans une position permettant la mesure de la température dudit dispositif supraconducteur (16).

2. Appareil supraconducteur selon la revendication 1, dans lequel ledit thermomètre à résistance (17) est un thermomètre à résistance de platine.

3. Appareil supraconducteur selon la revendication 1 ou la revendication 2, dans lequel ledit dispositif supraconducteur (16) est un dispositif magnétorésistif supraconducteur.

4. Appareil supraconducteur selon la revendication 3, dans lequel ledit dispositif magnétorésistif supraconducteur (16) est un détecteur magnétique.

5. Appareil supraconducteur selon la revendication 1 ou la revendication 2, dans lequel ledit dispositif supraconducteur (16) est un transistor supraconducteur.

6. Appareil supraconducteur selon la revendication 1 ou la revendication 2, dans lequel ledit dispositif supraconducteur (16) est un dispositif Josephson.

7. Appareil supraconducteur selon l'une quelconque des revendications précédentes, dans lequel ledit dispositif supraconducteur (16) est fixé sur ledit boîtier (50s) étanche à l'air au moyen d'une pâte d'Ag (18).

8. Appareil supraconducteur selon l'une quelconque des revendications précédentes, dans lequel ledit thermomètre à résistance (17) est fixé sur ledit boîtier (50s) étanche à l'air au moyen d'une pâte d'Ag (18).

9. Appareil supraconducteur selon l'une quelconque des revendications précédentes, dans lequel ledit boîtier étanche à l'air comprend une enceinte en céramique (50f) prise en sandwich entre un substrat en céramique (50s) et une plaque de verre (54), ledit dispositif supraconducteur (16) étant monté sur ledit substrat en céramique (50s).

10. Appareil supraconducteur selon la revendication 9, dans lequel lesdites bornes externes (71 - 74) sont montées sur la surface extérieure dudit substrat en céramique (50s).

11. Appareil supraconducteur selon la revendication 10, dans lequel chacune desdites bornes externes est une broche externe (par exemple 71) électriquement connectée à une borne interne (par exemple 19a) à l'intérieur de ladite enceinte en céramique (50f), ladite borne interne et ladite broche externe étant reliées par une ligne de connexion en Cu (par exemple 81) formée sur la surface dudit substrat en céramique (50s).

12. Appareil supraconducteur selon l'une quelconque des revendications précédentes, dans lequel ledit gaz est de l'azote.

13. Appareil supraconducteur selon l'une quelconque des revendications précédentes, dans lequel ledit gaz remplit ledit boîtier (50, 54) étanche à l'air à une pression de 1,11 x 10⁵ Nm⁻² (pression atmosphérique 1,1).
